## Europäisches Patentamt
## European Patent Office
## Office européen des brevets

(11) Numéro de publication: **0 182 681**
**B1**

(12) # FASCICULE DE BREVET EUROPÉEN

(45) Date de publication du fascicule du brevet:
**19.04.89**

(21) Numéro de dépôt: **85401998.1**

(22) Date de dépôt: **15.10.85**

(51) Int. Cl.⁴: **C 30 B 33/00,** C 23 C 8/10,
H 01 L 21/316

(54) Four d'oxydation de plaquettes en matériau semi-conducteur.

(30) Priorité: **17.10.84 FR 8415907**

(43) Date de publication de la demande:
**28.05.86 Bulletin 86/22**

(45) Mention de la délivrance du brevet:
**19.04.89 Bulletin 89/16**

(84) Etats contractants désignés:
**DE GB NL**

(56) Documents cité:
**FR-A-2 543 581**

**PATENTS ABSTRACTS OF JAPAN, vol. 8, no. 250 (E-279) 1687 , 16 novembre 1984; & JP - A - 59 126 641 (SUWA SEIKOSHA K.K.) 21.07.1984**

(73) Titulaire: **Buevoz, Jean- Louis, 31, rue J.J. Rousseau, F-38400 St Martin d'Heres (FR)**
Titulaire: **de Brebisson, Michel, 10, rue des Ayguinards, F-38240 Meylan (FR)**

(72) Inventeur: **Buevoz, Jean- Louis, 31, rue J.J. Rousseau, F-38400 St Martin d'Heres (FR)**
Inventeur: **de Brebisson, Michel, 10, rue des Ayguinards, F-38240 Meylan (FR)**

(74) Mandataire: **Martin, Jean- Jacques, Cabinet REGIMBEAU 26, Avenue Kléber, F-75116 Paris (FR)**

## Description

La présente invention concerne un four d'oxydation de plaquettes en matériau semi-conducteur.

La présente invention s'applique tout particulièrement à la fabrication de circuits intégrés. A titre d'exemple, le four d'oxydation conforme à la présente invention permet la création sur des plaquettes en silicium d'une couche mince en surface d'oxyde de silicium $SiO_2$.

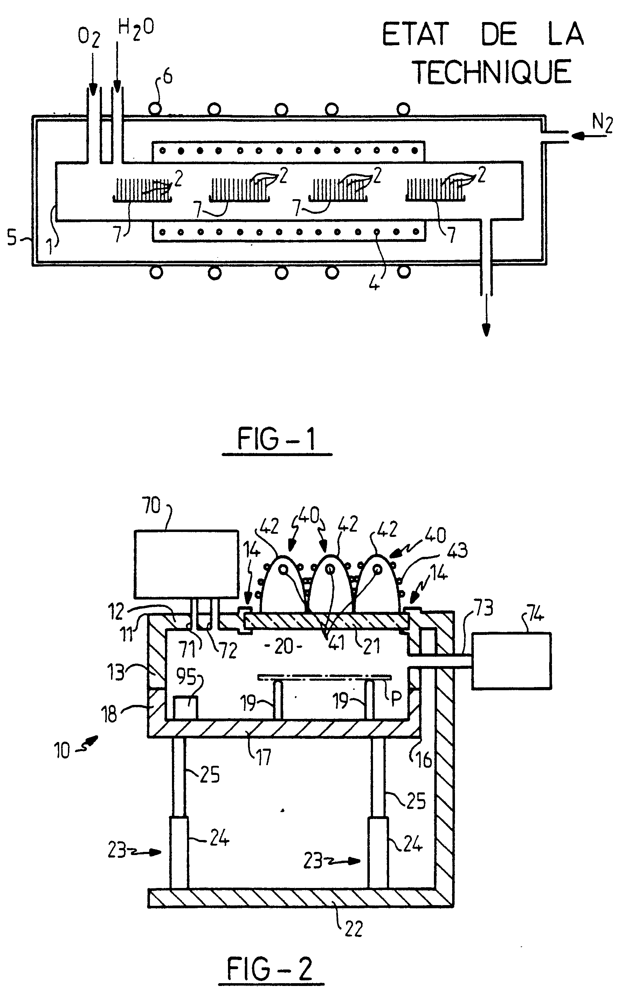

Les dispositifs classiques d'oxydation de plaquettes en matériau semi-conducteur, notamment pour la fabrication de circuits intégrés, sont formés, comme représenté schématiquement sur la figure 1 annexée, de fours d'oxydation thermique comprenant des tubes en quartz 1 dans lesquels sont introduites lesdites plaquettes 2 et qui sont chauffés par des résistances électriques 4 disposées sur l'extérieur du tube en quartz 1. Les plaquettes 2 à traiter sont supportées dans le tube 1 par des paniers en quartz 7. Les plaquettes 2 disposées dans le tube en quartz 1, lors du traitement sont soumises à une température élevée de l'ordre de 900 à 1100°C, dans une ambiance oxydante forcée par exemple d'oxygène ou d'un mélange d'oxygène et de vapeur d'eau.

A l'origine, les traitements étaient opérés sous une pression faible proche de la pression atmosphérique ambiante et demandaient environ une dizaine d'heures.

Néanmoins, dans la mesure où la vitesse d'oxydation croît avec la pression du gaz oxydant, il a été proposé ultérieurement pour limiter le temps de traitement de disposer l'espace interne 3 du tube en quartz 1 sous une pression de l'ordre de 50 bars.

Cette disposition exige en contrepartie l'application d'une contre-pression sur le tube de quartz 1 puisque celui-ci ne peut supporter les pressions et températures mises en jeu. Cette contre-pression est généralement réalisée comme représenté sur la figure 1 en disposant le tube de quartz 1 dans une enceinte externe 5, réalisée par exemple en acier, et soumise à une pression identique à celle régnant dans le tube.

L'enceinte externe 5 est refroidie par un système, par exemple à serpentin, référencé 6 sur la figure 1.

La pression interne de l'enceinte 5 est en général obtenue par alimentation de celle-ci en un gaz inerte sous pression, par exemple de l'azote.

Les fours d'oxydation de ce type actuellement proposés sur le marché comportent des tubes de quarts 1 de 2 à 5 m pouvant loger simultanément jusqu'à 200 plaquettes à traiter. Le temps de traitement est de l'ordre de trois heures.

Ces fours d'oxydation présentent cependant de nombreux inconvénients parmi lesquels on citera les risques très importants liés à l'utilisation de volumes importants de gaz sous haute pression, l'encombrement, le coût et le temps de traitement non négligeables imposés par les opérations de chargement, la mise sous pression, la montée et la descente en température.

Par ailleurs le chauffage à haute température du tube de quartz 1, par les résistances électriques 4, conduit à une contamination non négligeable des plaquettes traitées.

On a également proposé, comme décrit dans le document PATENT ABSTRACTS OF JAPAN Vol. 8 N° 250, JP-A-59 126 641, des dispositifs d'oxydation comprenant des tubes en quartz, recevant de l'oxygène sous faible pression, adaptés pour loger les plaquettes de matériau semi-conducteur à oxyder, chauffés par des moyens de chauffage spécifiques, et associés à des dispositifs d'irradiation dans le domaine ultraviolet afin d'augmenter la réactivité des molécules d'oxygène avec le matériau semi-conducteur.

Ces dispositifs présentent cependant divers inconvénients parmis lesquels on citera l'obtention d'une couche d'oxyde de qualité non pleinement satisfaisante, en raison notamment de la contamination inévitable due au chauffage des tubes en quartz, et un temps de traitement élevé.

Un système généralement similaire utilisant une source d'irradiation dans le domaine ultraviolet pour l'activation des molécules d'oxygène est décrit dans le document FR-A-2 543 581.

Le problème à résoudre est donc de concevoir un nouveau dispositif d'oxydation de plaquettes en matériau semi-conducteur qui soit plus économique que les fours d'oxydation classiques tout en étant moins dangereux et moins encombrant, en présentant un rendement au moins égal, et permettant d'obtenir une couche d'oxyde d'excellente qualité.

Le problème ainsi posé est résolu selon l'invention par un four d'oxydation de plaquettes en matériau semi-conducteur comprenant, de façon connue en soi de part le document FR-A-2 543 581:

- une chambre de traitement susceptible d'ouverture et dimensionnée pour l'insertion et la réception d'une seule plaquette à traiter,
- un hublot ménagé dans la paroi de la chambre de traitement et transparent au rayonnement électromagnétique émis par une source disposée à l'extérieur de la chambre et focalisé vers le hublot,
- des moyens d'alimentation de l'espace interne de la chambre de traitement en gaz oxydant sous pression,

caractérisé par le fait que:

- le rayonnement électromagnétique appartient au domaine du visible et proche infrarouge, et
- la source est constituée par des cellules d'insolation comprenant en combinaison des moyens émetterus du rayonnement électromagnétique et des moyens réflecteurs focalisant le rayonnement vers le hublot.

Le four d'oxydation conforme à la présente invention à en particulier pour avantage de permettre une réduction considérable du temps de traitement des plaquettes. Selon l'invention, le temps de traitement est en effet de l'ordre de quelques secondes à 3 minutes, alors que en utilisant les fours classiques, le processus de traitement exigeait plusieurs heures.

Le gain de temps obtenu selon l'invention s'explique comme suit.

Dans les fours classiques, les résistances 4 disposées sur l'extérieur du tube en quarts doivent assurer le chauffage de la totalité de la masse du tube et du contenu de celui-ci. En d'autres termes, les résistances 4 doivent chauffer des dizaines de kilogrammes. De plus, pour rechercher un traitement homogène des plaquettes, il est nécessaire de maintenir le système à température élevée pendant un temps important. Une inhomogénéité de température de quelques degrés suffit en effet pour perdre une partie au moins des plaquettes.

Par contre, grâce au four conforme à la présente invention, en particulier grâce à la structure des cellules d'insolation comprenant des moyens générant un rayonnement électromagnétique focalisé par des moyens réflecteurs pour traverser un hublot, seule la plaquette de quelques grammes est chauffée.

La chambre de traitement qui est par ailleurs de faible dimension est peu soumise au chauffage. L'inertie thermique du dispositif conforme à la présente invention est de ce fait quasi-nulle. De même la contamination des plaquettes est quasi-inexistante.

On notera par ailleurs que, en utilisant les fours d'oxydation classiques, un grand nombre de plaquettes - dans la majorité des cas la totalité des plaquettes contenues dans la chambre de traitement - devaient être éliminées lorsqu'une altération des conditions opératoires (température, pression, nature de l'asmosphère...) intervient en cours de traitement.

Par contre, selon l'invention, lorsque la chambre de traitement ne contient qu'une seule plaquette, seule celle-ci doit être éliminée en cas de mauvais traitement.

En conclusion, grâce au traitement rapide obtenu selon l'invention, il est possible, à rendement égal, d'opérer un contrôle beaucoup plus rigoureux sur les produits traités.

De façon avantageuse, la taille du hublot est sensiblement identique à la taille d'une plaquette à traiter, tandis que la chambre de traitement comprend des moyens aptes à supporter une plaquette à traiter en regard du hublot, sensiblement parallèlement à celui-ci. On obtient ainsi un temps de traitement minimal pour chaque plaquette.

La chambre de traitement est de préférence associée à des moyens à dépression aptes à opérer le vide dans celle-ci avant injection de gaz oxydant par les moyens d'alimentation.

L'utilisation de ces moyens à dépression permet de contrôler efficacement la nature des gaz contenus dans la chambre au cours du traitement.

Pour augmenter encore le rythme de traitement, le four d'oxydation conforme à la présente invention comprend préférentiellement un automate pour l'alimentation de la chambre en plaquettes et le retrait des plaquettes traitées hors de la chambre.

Selon un mode de réalisation préférentiel de la présente invention, la chambre de traitement est formée de deux coquilles susceptibles de déplacement relatif pour autoriser l'insertion et le retrait des plaquettes.

Les deux coquilles peuvent être susceptibles soit de translation relative soit de pivotement relatif.

Selon une autre caractéristique avantageuse de l'invention, la chambre de traitement comporte un sas de réserve. Selon le cas, le sas de réserve et la chambre de traitement peuvent être disposés dans une enceinte commune ou le sas de réserve peut communiquer avec la chambre de traitement par l'intermédiaire d'un portillon amovible.

De préférence, l'automate est disposé dans le sas de réserve.

Selon un mode de réalisation avantageux, l'automate comprend un panier portant une pluralité de plaquettes, porté à translation dans une première direction, et une canne de manutention portée à translation en regard du panier, transversalement à ladite première direction.

Selon une autre caractéristique avantageuse de l'invention, chaque cellule d'innolation comprend en combinaison une lampe et un réflecteur parabolique.

De préférence, les moyens réflecteurs sont de plus associés à un système de refroidissement.

D'autres caractéristiques et avantages de la présente invention apparaîtront à la lecture de la description détaillée qui va suivre et en regard des dessins annexés sur lesquels, la figure 1 qui représente l'état de la technique ayant déjà été décrite:

- la figure 2 représente une vue schématique en coupe verticale d'un four d'oxydation conforme à une première variante de réalisation de la présente invention, en position fermée,
- la figure 3 représente une vue schématique en coupe verticale du même four d'oxydation conforme à la première variante de réalisation de la présente invention, en position ouverte, autorisant l'insertion et/ou ou le retrait d'une plaquette à traiter ou traitée, par un automate associé,
- la figure 4 représente une vue schématique en coupe verticale d'un four d'oxydation conforme à une seconde variante de réalisation de la présente invention, en position ouverte,
- la figure 5 représente une vue schématique en coupe verticale d'un four d'oxydation conforme à une troisième variante de réalisation de la présente invention, en position ouverte,

- la figure 6 représente une vue schématique en coupe verticale d'un four d'oxydation conforme à une quatrième variante de réalisation de la présente invention, comprenant un automate disposé dans un sas de réserve, ce dernier étant représenté en position ouverte en vue d'un chargement,

la figure 7 représente une vue en coupe du même four d'oxydation conforme à la quatrième variante de réalisation de la présente invention dans une position de communication entre le sas de réserve et la chambre de traitement en vue d'un transfert de plaquettes à traiter et/ou traitées.

D'une façon générale, le four d'oxydation conforme à la présente invention comprend une chambre de traitement 10, des cellules d'insolation 40, et des moyens 70 d'alimentation de la chambre de traitement 10 en un gaz oxydant.

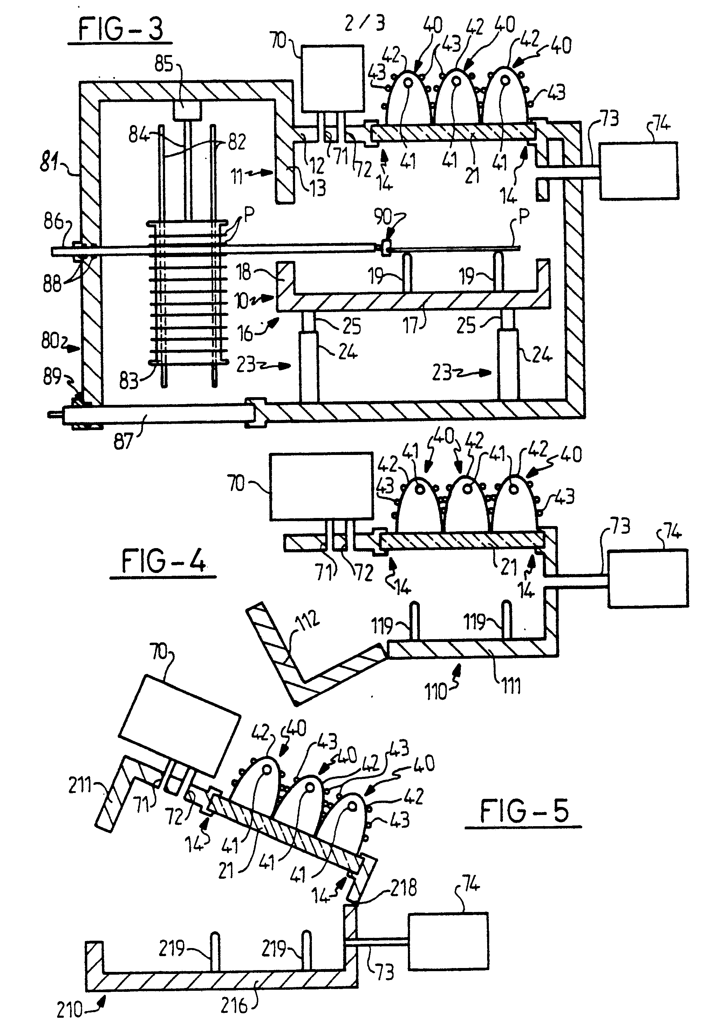

Selon le mode de réalisation représenté sur les figures 2 et 3, la chambre de traitement 10 est formée de deux coquilles 11 et 16 respectivement supérieure et inférieure, superposées verticalement, et susceptibles de déplacement relatif afin d'autoriser l'insertion de plaquettes en matériau semi-conducteur dans l'espace interne 20 de la chambre en vue d'un traitement.

Les coquilles 11 et 16 sont avantageusement réalisées en acier ou en tout autre matériau métallique résistant à la pression et économique.

La coquille supérieure 11 est formée d'une paroi supérieure 12 équipée d'un hublot 21, et solidaire d'une paroi latérale 13 en saillie vers le bas.

La coquille inférieure 16 est formée d'une paroi inférieure 17 solidaire d'une paroi latérale périphérique 18 en saillie vers le haut.

Le hublot 21 réalisé de préférence en quartz est fixé dans la paroi supérieure 12, de façon étanche aux gaz, à l'aide de tout moyen classique approprié, tel que cela est schématiquement illustré sous forme d'une monture périphérique 14 sur les figures 2 et 3.

La coquille supérieure 11 est par ailleurs solidaire d'une embase support 22.

Cette dernière porte en outre les corps 24 de vérins 23 s'étendant généralement verticalement en-dessous de la chambre 10 et dont les tiges 25 sont solidaires de la coquille inférieure 16.

La paroi inférieure 17 porte des supports de plaquette 19 s'étendant verticalement vers l'intérieur 20 de la chambre de traitement.

Ces supports 19 sont adaptés pour soutenir une plaquette P à traiter (représentée en traits interrompus sur la figure 2) en regard du hublot 21, sensiblement parallèlement au hublot 21. Le hublot 21 possède une taille sensiblement identique à la taille des plaques à traiter P.

Ce hublot 21 est transparent au rayonnement électromagnétique du domaine visible et proche infra-rouge émis par les cellules d'insolation 40 disposées sur l'extérieur de la chambre de traitement 10.

Plus précisément, chaque cellule d'insolation 40 comprend un élément émetteur 41 générant un rayonnement électromagnétique compris dans le domaine visible et proche infra-rouge et un système réflecteur 42 focalisant le rayonnement généré par les éléments émetteurs 41 vers le hublot 21, pour chauffer les plaquettes.

De préférence, l'élément émetteur 41 est une lampe telle qu'un tube allongé parallèle au hublot 21 et le système réflecteur 42 est du type parabolique (de forme allongée dans le cas ou l'élément 41 est un tube).

De préférence, les réflecteurs 42 sont associés à des moyens de refroidissement 43 comportant des serpentins disposés sur l'arrière des réflecteurs 42 et dans lesquels circule un liquide froid, tel que de l'eau.

Les réflecteurs 42 disposés sur l'extérieur du hublot 21 peuvent servir à soutenir celui-ci à l'encontre de la pression interne de la chambre exercée par les moyens d'alimentation 70.

Les moyens d'alimentation 70 en gaz oxydant, classiques en eux-mêmes ne seront pas décrits en détail.

Ces moyens d'alimentation 70 communiquent avec l'espace interne 20 de la chambre de traitement 10 par deux conduits 71, 72 traversant la paroi supérieure 12 et permettant l'alimentation de cet espace interne 20 respectivement en oxygène et en vapeur d'eau.

Les moyens d'alimentation 70 permettent ainsi de soumettre les plaquettes à traiter à une ambiance oxydante formée soit d'oxygène, soit d'un mélange d'oxygène et de vapeur d'eau.

De plus, la paroi latérale 13 de la coquille supérieure 11 porte un conduit traversant 73 relié à des moyens à dépression 74 permettant d'opérer le vide dans la chambre de traitement et le cas échéant, de mettre en communication l'espace interne 20 de la chambre de traitement 10 et l'extérieur.

La chambre de traitement 10 peut être de préférence régulée en température à l'aide d'éléments refroidissants/chauffants électriques thermostatés, schématiquement représentés 95 sur la figure 2.

De préférence, comme cela est représenté sur la figure 3, le four d'oxydation qui vient d'être décrit est combiné à un automate 80 assurant d'une part l'alimentation de la chambre 10 en plaquettes P à traiter, d'autre part le retrait des plaquettes traitées hors de la chambre.

Selon le mode de réalisation représenté sur la figure 3, l'automate 80 est disposé dans une enceinte 81 logeant également la chambre de traitement 10.

Plus précisément, la paroi supérieure 12 de la chambre de traitement 10, équipée du hublot 21, est solidaire de la paroi supérieure de l'enceinte 81, tandis que la paroi inférieure de l'enceinte supporte les corps 24 des vérins 23 commandant le déplacement de la coquille inférieure 16 de la chambre de traitement.

L'automate 80 comprend des rails verticaux 82 guidant en translation un panier 83 en quartz du type à ratelier portant une pluralité de plaquettes P adjacentes et parallèles en position générale horizontale.

Le panier 83 est entraîné le long des rails 82 par un système d'entraînement comprenant par exemple une tige filetée 84 actionnée par un moteur 85 et venant en prise avec un alésage fileté ménagé dans le panier 83. Le déplacement du panier 83 peut néanmoins être commandé par tout moyen fonctionnellement équivalent.

L'automate 80 comprend en outre une canne de manutention 86 portée en translation horizontale en regard du panier 83 par une paroi de l'enceinte 81.

La canne de manutention 86 est adaptée comme cela apparaît à l'examen de la figure 3 pour déplacer une plaque P à traiter du panier 83 sur les supports 19 puis ramener les plaques traitées sur le panier 83.

L'extrémité de la canne de manutention 86 coopérant avec les plaquettes P peut être équipée à cet effet d'un système de pince 90 ou de tout autre moyen équivalent.

L'enceinte 81 comprend un portillon 87 pivotant ou déplaçable en translation, en regard de l'automate 80, par exemple dans la paroi inférieure de l'enceinte pour le retrait et le rechargement du panier 83.

De façon avantageuse, des moyens d'étanchéité 88, 89 sont disposés aux niveaux des interfaces entre l'enceinte 81 et la canne de manutention 86 d'une part, l'enceinte 81 et le portillon 87 d'autre part.

Le fonctionnement du four d'oxydation représenté sur la figure 3 est le suivant.

Dans un premier temps, le portillon 87 est ouvert et un panier 83 équipé d'une pluralité de plaquettes à traiter P est engagé sur les rails 82. La canne de manutention 86 fait saillie sur l'extérieur de l'enceinte 81.

Le moteur 85 est actionné pour déplacer le panier 83 à l'intérieur de l'enceinte 81.

Le portillon 87 est alors fermé puis la chambre de traitement 10 ouverte par commande des vérins 23.

Le vide est opéré dans l'enceinte par les moyens 74 puis la canne de manutention 86 est poussée dans l'enceinte 81 pour déplacer une première plaquette P à traiter du panier 83 sur les supports 19, déposer la plaquette sur ceux-ci, puis est retirée.

La chambre de traitement 10 est fermée, par actionnement des vérins 23, pendant un temps de traitement de l'ordre de 10 sec. à 3 mn.

Les moyens 70 assurent la montée en pression de l'enceinte sous atmosphère oxydante ($O_2$ et $H_2O$). En parallèle, les lampes 41 sont alimentées pour chauffer la plaquette.

A la fin du processus de traitement, la chambre de traitement 10 est de nouveau ouverte et la plaquette P traitée retirée à l'aide de la canne de manutention 86, des supports 19 sur le panier 83.

Ce dernier est alors avancé d'un pas sur les rails 82 afin de disposer une nouvelle plaquette P à traiter en regard de la canne de manutention 86. Celle-ci pousse cette nouvelle plaquette sur les supports 19 et les opérations de fermeture et ouverture précitées de la chambre 10 sont réitérées.

Lorsque toutes les plaquettes disposées sur le panier ont été ainsi traitées par oxydation, le portillon 87 est de nouveau ouvert et le panier 83 retiré des rails.

De nombreuses variantes peuvent être envisagées pour la réalisation de la chambre de traitement.

Selon le mode de réalisation représenté sur la figure 4, la chambre de traitement 110 comprend un carter 111 équipé du hublot 21 dans l'une de ses parois (de préférence la paroi supérieure) et muni par ailleurs d'un portillon pivotant 112 permettant l'insertion d'une plaquette à traiter sur des supports 119 (solidaires de préférence de la paroi inférieure, et le retrait ultérieur des plaquettes traitées.

Selon le mode de réalisation représenté sur la figure 5, la chambre de traitement 210 comprend deux coquilles 211 et 216 similaires aux coquilles 11 et 16 évoquées en regard des figures 2 et 3, mais susceptibles de pivotement relatif autour d'un axe horizontal 218. Là encore, la paroi supérieure de la chambre est munie du hublot, tandis que la paroi inférieure de la chambre porte les supports 219.

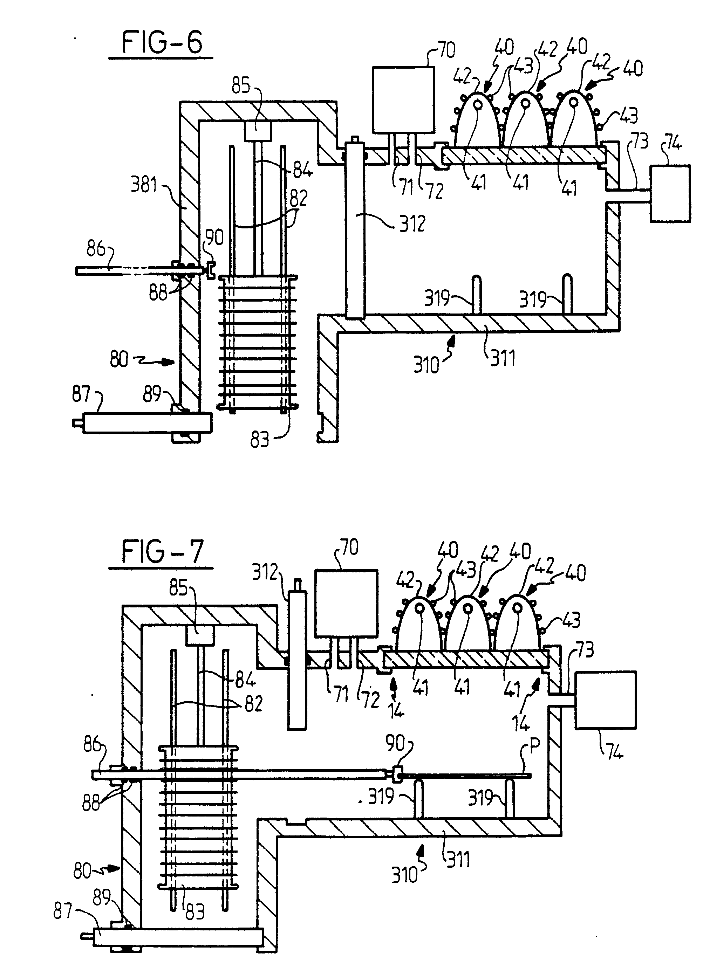

Selon le mode de réalisation représenté sur les figures 6 et 7, la chambre de traitement 310 comprend un carter 311 équipé du hublot 21 dans l'une de ses parois (de préférence la paroi supérieure) et muni d'un portillon 312 susceptible de translation pour mettre en communication un sas de réserve 381 logeant l'automate 80 précité et cette chambre 310. De façon similaire à l'enceinte 81 illustrée sur la figure 3, le sas de réserve 381 comporte un portillon 87 en regard de l'automate, et plus précisément en regard du panier 83, pour assurer le retrait et le rechargement de ce dernier.

Les cellules d'insolation 40, les moyens d'alimentation 70 en gaz oxydant et les moyens à dépression 74 équipant les chambres de traitement 110, 210 et 310 représentées sur les figures 4, 5, 6 et 7 sont similaires aux éléments évoqués en regard des figures 2 et 3 et ne seront donc pas décrits à nouveau.

La géométrie de la chambre de traitement, du sas de réserve et de l'enceinte représentés sur les figures en particulier ne doit pas être considérée comme limitative.

Par ailleurs, on peut envisager d'utiliser deux paniers 83 pour assurer les transferts de plaquettes, l'un qui est chargé en plaquettes traitées provenant de la chambre de traitement et l'autre qui est déchargée des plaquettes à traiter vers la chambre.

Dans le cas où une couche d'oxyde doit être déposée sur les deux côtés de la plaquette, la structure de la chambre de traitement peut aisément être adaptée pour supporter deux ensembles de cellules d'insolation en regard de hublots respectifs opposés.

On notera que, à la différence des tubes en quarts des fours classiques, la chambre de traitement conforme à la présente invention reste à une faible température (toujours inférieure à 300°C) ce qui permet l'utilisation de solutions techniques ordinaires (aciers ordinaires, joints ordinaires), d'où un prix de revient très réduit et une grande fiabilité.

## Revendications

1. Four d'oxydation de plaquettes en matériau semi-conducteur comprenant:
   - une chambre de traitement (10, 110, 210, 310) susceptible d'ouverture et dimensionnée pour l'insertion et la réception d'une seule plaquette à traiter,
   - un hublot (21) ménagé dans la paroi de la chambre de traitement et transparent au rayonnement electromagnétique émis par une source disposée à l'extérieur de la chambre et focalisé vers le hublot,
   - des moyens (70) d'alimentation de l'espace interne de la chambre de traitement en gaz oxydant sous pression,
   
   caractérisé par le fait que:
   - le rayonnement électromagnétique appartient au domaine du visible et proche infrarouge, et
   - la source est constituée par des cellules d'insolation comprenant en combinaison des moyens (41) émetteurs de rayonnement électromagnétique et des moyens réflecteurs focalisant le rayonnement vers le hublot.

2. Dispositif d'oxydation selon la revendication 1, caractérisé par le fait que la taille du hublot (21) est sensiblement identique à la taille d'une plaquette a traiter (P).

3. Dispositif d'oxydation selon l'une des revendications 1 à 2, caractérisé par le fait que la chambre de traitement (10, 110, 210, 310) comprend des moyens (19, 119, 219, 319) aptes à supporter une plaquette (P) à traiter en regard du hublot (21), sensiblement parallèment à celui-ci.

4. Dispositif d'oxydation selon l'une des revendications 1 à 3, caractérisé par le fait que la chambre de traitement (10) est régulée en température à l'aide de moyens thermostatés (95).

5. Dispositif d'oxydation selon l'une des revendications 1 à 4, caractérisé par le fait que la chambre de traitement (10, 110, 210, 310) est associée à des moyens à dépression (74) aptes à opérer le vide dans celle-ci avant injection de gaz oxydant par les moyens d'alimentation (70).

6. Dispositif d'oxydation selon l'une des revendications 1 à 5, caractérisé par le fait qu'il comprend un automate (80) pour l'alimentation de la chambre (10, 110, 210, 310) en plaquettes (P) et le retrait des plaquettes traitées hors de la chambre.

7. Dispositif d'oxydation selon l'une des revendications 1 à 6, caractérisé par le fait que la chambre de traitement (10, 210) est formée de deux coquilles (11, 16; 211, 216) susceptibles de déplacement relatif pour autoriser l'insertion et le retrait des plaquettes (P).

8. Dispositif d'oxydation selon la revendication 7, caractérisé par le fait que les deux coquilles (11, 16) sont susceptibles de translation relative.

9. Dispositif d'oxydation selon la revendication 7, caractérisé par le fait que les deux coquilles (211, 216) sont susceptibles de pivotement relatif.

10. Dispositif d'oxydation selon l'une des revendications 1 à 6, caractérisé par le fait que la chambre de traitement (310) comporte une porte (312) débouchant dans un sas de réserve (381).

11. Dispositif d'oxydation selon les revendications 6 et 10, prises en combinaison, caractérisé par le fait que l'automate (80) est disposé dans le sas de réserve (381).

12. Dispositif d'oxydation selon l'une des revendications 1 à 11, prise en combinaison avec la revendication 6, caractérisé par le fait que l'automate (80) est formé d'un panier (83) portant une pluralité de plaquettes (P), porté à translation dans une première direction, et une canne de manutention (86) portée à translation en regard du panier, transversalement à ladite première direction.

13. Dispositif d'oxydation selon l'une des revendications 1 à 12, caractérisé par le fait que chaque cellule d'insolation (40) comprend en combinaison une lampe (41) et un réflecteur parabolique (42).

14. Dispositif d'oxydation selon l'une des revendications 1 à 13, caractérisé par le fait qu'il comprend un système de refroidissement (43) associé aux moyens réflecteurs (42).

15. Four d'oxydation selon l'une des revendications 1 à 14, caractérisé par le fait que les cellules d'insolation (40) sont adaptées pour porter les plaquettes (P) à traiter à une température supérieure à 1000°C.

16. Four d'oxydation selon la revendication 15, caractérisé par le fait que les cellules d'insolutation (40) sont adaptées pour porter les plaquettes (P) à traiter à une température de l'ordre de 1100°C.

17. Four d'oxydation selon l'une des revendications 1 à 16, caractérisé par le fait que les moyens (70) d'alimentation en gaz oxydant sont adaptés pour porter la chambre de traitement sous une pression supérieure à 70 bars.

18. Four d'oxydation selon la revendication 17, caractérisé par le fait que les moyens (70) d'alimentation en gaz oxydant sont adaptés pour porter la chambre de traitement sous une pression de l'ordre de 75 bars.

## Patentansprüche

1. Oxidationsofen für Halbleiterplättchen, mit
- einer Behandlungskammer (10; 110; 210; 310), die sich öffnen läßt und für das Einführen und die Aufnahme eines einzigen zu behandelnden Plättchens bemessen ist,
- einem Fenster (21), das in der Wand der Behandlungskammer ausgebildet ist und für elektromagnetische Strahlung durchlässig ist, welche von einer außerhalb der Kammer angeordneten und in Richtung zum Fenster fokussierten Quelle ausgesandt wird,
- Einrichtungen (70) zum Versorgen des Innenraums der Behandlungskammer mit oxidierendem Druckgas,
dadurch gekennzeichnet, daß
- die elektromagnetische Strahlung zum Gebiet des sichtbaren Lichts und des nahen Infrarot gehört, und
- die Quelle von Einstrahlungszellen gebildet ist, welche Einrichtungen (41) zum Aussenden elektromagnetischer Strahlung in Kombination mit die Strahlung auf das Fenster fokussierenden reflektierenden Einrichtungen umfaßt.

2. Oxidationsvorrichtung nach Anspruch 1, dadurch gekennzeichnet, daß die Größe des Fensters (21) im wesentlichen gleich ist mit der eines zu behandelnden Plättchens (P).

3. Oxidationsvorrichtung nach einem der Ansprüche 1 bis 2, dadurch gekennzeichnet, daß die Behandlungskammer (10; 110; 210; 310) Einrichtungen (19; 119; 219; 319) umfaßt, welche ein zu behandelndes Plättchen (P) dem Fenster (21) gegenüber im wesentlichen parallel zu letzterem abzustützen vermögen.

4. Oxidationsvorrichtung nach einem der Ansprüche 1 bis 3, dadurch gekennzeichnet, daß die Behandlungskammer (10) mittels thermostabilisierter Einrichtungen (95) temperaturreguliert ist.

5. Oxidationsvorrichtung nach einem der Ansprüche 1 bis 4, dadurch gekennzeichnet, daß die Behandlungskammer (10; 110; 210; 310) mit Unterdruckeinrichtungen (74) verbunden ist, die sie vor dem Einleiten von oxidierendem Gas durch die Versorgungseinrichtungen (70) zu evakuieren vermögen.

6. Oxidationsvorrichtung nach einem der Ansprüche 1 bis 5, dadurch gekennzeichnet, daß sie einen Automaten (80) für die Aufgabe von Plättchen (P) in die Kammer (10; 110; 210; 310) und zum Entnehmen der behandelten Plättchen aus der Kammer aufweist.

7. Oxidationsvorrichtung nach einem der Ansprüche 1 bis 6, dadurch gekennzeichnet, daß die Behandlungskammer (10; 210) von zwei Schalen (11, 16; 211, 216) gebildet ist, die zum Ermöglichen des Aufgebens und Entnehmens der Plättchen (P) relativ zueinander bewegbar sind.

8. Oxidationsvorrichtung nach Anspruch 1, dadurch gekennzeichnet, daß die beiden Schalen (11, 16) relativ zueinander translatorisch bewegbar sind.

9. Oxidationsvorrichtung nach Anspruch 7, dadurch gekennzeichnet, daß die beiden Schalen (211, 216) relativ zueinander schwenkbar sind.

10. Oxidationsvorrichtung nach einem der Ansprüche 1 bis 6, dadurch gekennzeichnet, daß die Behandlungskammer (310) eine in eine Reserveschleuse (381) gehende Tür (312) aufweist.

11. Oxidationsvorrichtung nach Anspruch 6 und 10 in Verbindung miteinander, dadurch gekennzeichnet, daß der Automat (80) in der Reserveschleuse (381) angeordnet ist.

12. Oxidationsvorrichtung nach einem der Ansprüche 1 bis 11 in Verbindung mit Anspruch 6, dadurch gekennzeichnet, daß der Automat (80) von einem eine Vielzahl von Plättchen (P) tragenden, translatorisch in einer ersten Richtung bewegbaren Korb (83) und von einer Handhabungsstange (86), die in bezug auf den Korb translatorisch quer zur ersten Richtung bewegbar ist, gebildet ist.

13. Oxidationsvorrichtung nach einem der Ansprüche 1 bis 12, dadurch gekennzeichnet, daß jede Einstrahlungszelle (40) eine Lampe (41) in Kombination mit einem parabolischen Reflektor (42) umfaßt.

14. Oxidationsvorrichtung nach einem der Ansprüche 1 bis 13, dadurch gekennzeichnet, daß sie ein mit den reflektierenden Einrichtungen (42) verbundenes Kühlsystem (43) umfaßt.

15. Oxidationsofen nach einem der Ansprüche 1 bis 14, dadurch gekennzeichnet, daß die Einstrahlungszellen (40) so ausgebildet sind, daß sie die zu behandelnden Plättchen (P) auf eine höhere Temperatur als 1000° C erwärmen.

16. Oxidationsofen nach Anspruch 15, dadurch gekennzeichnet, daß die Einstrahlungszellen (40) so ausgebildet sind, daß sie die zu behandelnden Plättchen (P) auf eine Temperatur von etwa 1100° C erwärmen.

17. Oxidationsofen nach einem der Ansprüche 1 bis 16, dadurch gekennzeichnet, daß die Einrichtungen (70) zur Versorgung mit oxidierendem Gas so ausgebildet sind, daß sie in der Behandlungskammer einen Druck von mehr als 70 bar erzeugen.

18. Oxidationsofen nach Anspruch 17, dadurch gekennzeichnet, daß die Einrichtungen (70) zur Versorgung mit oxidierendem Gas so ausgebildet sind, daß sie in der Behandlungskammer einen Druck von etwa 75 bar erzeugen.

## Claims

1. A furnace for oxidizing wafers of semiconductor material, the furnace comprising:
- a processing chamber (10, 110, 210, 310) capable of being opened and sized for inserting and receiving a single wafer to be processed,
- a window (21) provided through the wall of the processing chamber and transparent to electromagnetic radiation generated by an emitter means provided outside the chamber and focused towards the window,

- means (70) for feeding the inside volume of the processing chamber with an oxidizing gas under pressure,

characterised by the fact that

- the electromagnetic radiation belongs to the visible and near infrared regions of the spectrum, and

- the emitter means is formed by radiating cells comprising in combination emitter means (41) generating electromagnetic radiation and reflector means focusing the radiation towards the window.

2. An oxidizing furnace according to claim 1, wherein the window (21) is of substantially identical size to a wafer (P) to be processed.

3. An oxidizing furnace according to one of claims 1 or 2, wherein the processing chamber (10, 110, 210, 310) includes means (19, 119, 219, 319) suitable for supporting a wafer (P) to be processed facing the window (21), and substantially parallel thereto.

4. An oxidizing furnace according to one of claims 1 to 3, wherein the processing chamber (10) is temperature regulated by thermostatic means (95).

5. An oxidizing furnace according to one of claims 1 to 4, wherein the processing chamber (10, 110, 210, 310) is associated with means (74) for reducing the pressure therein in order to evacuate the processing chamber prior to injecting the oxidizing gas from the feed means (70).

6. An oxidizing furnace according to one of claims 1 to 5, including a robot (80) for feeding the processing chamber (10, 110, 210, 310) with wafers (P) and for removing processed wafers from the chamber.

7. An oxidizing furnace according to one of claims 1 to 6, wherein the processing chamber (10, 210) is made up from two shells (11, 16; 211, 216) capable of relative displacement to enable wafers (P) to be inserted and removed from the chamber.

8. An oxidizing furnace according to claim 7, wherein the two shells (11, 16) are capable of relative translation.

9. An oxidizing furnace according to claim 7, wherein the two shells (211, 216) are capable of relative pivoting.

10. An oxidizing furnace according to one of claims 1 to 6, wherein the processing chamber (310) includes a gate (312) giving access to a supply airlock (381).

11. An oxidizing furnace according to claims 6 and 10 taken into combination, wherein said robot (80) is disposed inside the supply airlock (381).

12. An oxidizing furnace according to one of claims 1 to 11 taken into combination with claim 6, wherein the robot (80) is constituted by a rack (83) carrying a plurality of wafers (P) and moved in translation along a first direction, together with a wafer-handling arm (86) moved in translation transversely to said first direction and through or past said rack.

13. An oxidizing furnace according to one of claims 1 to 12, wherein each radiation cell (40) comprises, in combination, a lamp (41) and a parabolic reflector (42).

14. An oxidizing furnace according to one of claims 1 to 13, including a cooling system (43) associated with said reflector means (42).

15. An oxidizing furnace according to one of claims 1 to 14, wherein the radiation cells (40) are suitable for raising the temperature of the wafers (P) to be processed to a temperature which is greater than 1000° C.

16. An oxidizing furnace according to claim 15 wherein the radiation cells (40) are suitable for raising the temperature of the wafers (P) to be processed to a temperature about 1100° C.

17. An oxidizing furnace according to one of claims 1 to 16, wherein the means (70) for supplying oxidizing gas are suitable for raising the pressure of the processing chamber to a pressure which is greater than 70 bars.

18. An oxidizing furnace according to claim 17 wherein the means (70) for supplying oxidizing gas are suitable for raising the processing chamber to a pressure about 75 bars.

ETAT DE LA
TECHNIQUE

FIG - 1

FIG - 2

1

FIG-3

FIG-4

FIG-5

## FIG-6

## FIG-7